(19) Europäisches Patentamt / European Patent Office / Office européen des brevets

(11) **EP 4 524 205 A1**

(12) **EUROPEAN PATENT APPLICATION**
published in accordance with Art. 153(4) EPC

(43) Date of publication:
**19.03.2025   Bulletin 2025/12**

(21) Application number: **23803455.7**

(22) Date of filing: **27.04.2023**

(51) International Patent Classification (IPC):
*C08L 101/00* (2006.01)   *B32B 15/08* (2006.01)
*B32B 27/20* (2006.01)   *C08J 5/24* (2006.01)
*C08K 3/22* (2006.01)   *C08K 3/24* (2006.01)
*C08L 25/08* (2006.01)   *H01Q 13/08* (2006.01)
*H05K 1/03* (2006.01)

(52) Cooperative Patent Classification (CPC):
**B32B 15/08; B32B 27/20; C08J 5/24; C08K 3/22; C08K 3/24; C08L 25/08; C08L 101/00; H01Q 13/08; H05K 1/03**

(86) International application number:
**PCT/JP2023/016561**

(87) International publication number:
**WO 2023/218976 (16.11.2023 Gazette 2023/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **13.05.2022   JP 2022079768**

(71) Applicant: **Resonac Corporation**
**Tokyo 105-7325 (JP)**

(72) Inventors:
• **HIRAYAMA Yuya**
**Tokyo 105-7325 (JP)**
• **OJI Masashi**
**Tokyo 105-7325 (JP)**
• **SHIMAYAMA Yuichi**
**Tokyo 105-7325 (JP)**
• **YAMAGUCHI Masaki**
**Tokyo 105-7325 (JP)**
• **WATASE Yusuke**
**Tokyo 105-7325 (JP)**

(74) Representative: **Hoffmann Eitle**
**Patent- und Rechtsanwälte PartmbB**
**Arabellastraße 30**
**81925 München (DE)**

(54) **HEAT-CURABLE RESIN COMPOSITION, PREPREG, RESIN FILM, LAMINATE, PRINTED WIRING BOARD, ANTENNA DEVICE, ANTENNA MODULE, AND COMMUNICATION DEVICE**

(57)    Provided is a thermosetting resin composition that contains a high dielectric constant material and that can suppress, in producing a cured product thereof, generation of outgas, decrease in heat resistance, and decrease in peel strength. Also provided are a prepreg, a resin film, a laminate, a printed wiring board, an antenna device, an antenna module, and a communication device obtained by using the thermosetting resin composition. The thermosetting resin composition is, specifically, a thermosetting resin composition containing (A) a thermosetting resin and (B) at least one high dielectric constant inorganic filler selected from the group consisting of a titanium-based inorganic filler and a zircon-based inorganic filler, the thermosetting resin composition further containing (C) a resin having 3% by mass or more of an acidic group in an amount of 1 part by mass or more with respect to 100 parts by mass of the component (B).

**EP 4 524 205 A1**

## Description

Technical Field

The present disclosure relates to a thermosetting resin composition, a prepreg, a resin film, a laminate, a printed wiring board, an antenna device, an antenna module, and a communication device.

Background Art

In recent years, mobile terminals such as smartphones have become popular, and as a result of technological innovation such as the Internet of Things (IoT), home appliances and electronic devices having a wireless communication function have increased. This raises a concern that the communication traffic of the wireless network increases and the communication speed and the communication quality are reduced.

In order to solve the problem, the development of the Fifth Generation Mobile Communication System (hereinafter, sometimes referred to as "5G") is in progress, and the 5G system is already being used. In 5G, advanced beam forming and spatial multiplexing are performed using a plurality of antenna elements, and in addition to signals of frequencies in the 6 GHz band that have been used conventionally, signals of millimeter wave bands with higher frequencies such as several tens of GHz are used. Accordingly, it is expected that the communication speed is increased and the communication quality is improved. Hereinafter, a frequency of 10 GHz or higher is referred to as a high frequency.

As described above, in 5G, it is necessary for the antenna module to be capable of coping with high-frequency signals, and for this purpose, it is required that the dielectric constant (Dk) and the dielectric dissipation factor (Df) of the laminate in a high-frequency band be low, and in particular, that the dielectric dissipation factor (Df) be low.

Since radio waves of high frequencies have high linearity, signals carried on radio waves of high frequencies tend to be easily blocked by obstacles such as buildings. Therefore, in order to avoid the blocking, a plurality of antenna devices are mounted on the antenna module. Since the antenna device can be downsized by increasing the dielectric constant (Dk) of a substrate material, increasing the dielectric constant (Dk) is effective for mounting a plurality of antenna devices, and leads to downsizing of the antenna module, which in turn leads to downsizing of the communication device. Therefore, the laminate used in the antenna module that is capable of coping with high-frequency signals is required to have a dielectric constant (Dk) of a predetermined level and a low dielectric dissipation factor (Df).

Here, as one of the methods for increasing the dielectric constant (Dk) of the substrate material, a method using a high dielectric constant material is mentioned (for example, refer to PTL 1). The small antenna described in PTL 1 is produced by interposing a first dielectric layer of a low dielectric constant material between a second and a third dielectric layer of a high dielectric constant material and laminating the layers.

Citation List

Patent Literature

PTL 1: WO 2005/101574

Summary of Invention

Technical Problem

Although a titanate salt and the like are widely known as a high dielectric constant material, it has been found in studies of the present inventors that, when a thermosetting resin composition containing a titanate salt or the like is placed under a heating condition for producing a cured product for an antenna device using the composition, problems occur in that (1) a large amount of outgas (volatile gas) is generated, (2) the heat resistance of the cured product decreases, and (3) the strength against peeling between the cured product and a copper foil (hereinafter referred to as "peel strength") decreases, whereby the reliability of the antenna device decreases.

The present disclosure has been made in view of the above circumstance, and has an object to provide a thermosetting resin composition that contains a high dielectric constant material and that can suppress, in producing a cured product thereof, generation of outgas, decrease in heat resistance, and decrease in peel strength, and to provide a prepreg, a resin film, a laminate, a printed wiring board, an antenna device, an antenna module, and a communication device produced by using the thermosetting resin composition.

Solution to Problem

As a result of intensive and extensive studies, the present inventors have found that the object can be achieved by the thermosetting resin composition of the present disclosure.

The present disclosure includes the following [1] to [15].

[1] A thermosetting resin composition containing:

(A) a thermosetting resin; and
(B) at least one high dielectric constant inorganic filler selected from the group consisting of a titanium-based inorganic filler and a zircon-based inorganic filler,

the thermosetting resin composition further containing (C) a resin having 3% by mass or more of an acidic group in an amount of 1 part by mass or more with respect to 100 parts by mass of the component (B).

[2] The thermosetting resin composition according to [1], in which the acidic group of the component (C) is at least one selected from the group consisting of a carboxylic anhydride group, a carboxy group, a sulfo group, and a phenolic hydroxy group.

[3] The thermosetting resin composition according to [1] or [2], in which the component (C) is a copolymer resin of an aromatic vinyl compound and maleic anhydride.

[4] The thermosetting resin composition according to any one of [1] to [3], in which the titanium-based inorganic filler is at least one selected from the group consisting of titanium dioxide and a metal titanate.

[5] The thermosetting resin composition according to [4], in which the metal titanate is at least one selected from the group consisting of an alkali metal titanate, an alkaline earth metal titanate, and lead titanate.

[6] The thermosetting resin composition according to any one of [1] to [5], in which the zircon-based inorganic filler is an alkali metal zirconate.

[7] The thermosetting resin composition according to any one of [1] to [6], in which the component (B) is contained in an amount of 1 to 60% by volume based on a total amount of solid components in the thermosetting resin composition.

[8] The thermosetting resin composition according to any one of [1] to [7], in which the component (A) contains at least one selected from the group consisting of an epoxy resin, a maleimide compound, a modified polyphenylene ether resin, a phenol resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.

[9] A prepreg containing the thermosetting resin composition according to any one of [1] to [8] or a semi-cured product of the thermosetting resin composition.

[10] A resin film containing the thermosetting resin composition according to any one of [1] to [8] or a semi-cured product of the thermosetting resin composition.

[11] A laminate including a cured product of the thermosetting resin composition according to any one of [1] to [8] or a cured product of the prepreg according to [9], and a metal foil.

[12] A printed wiring board including one or more selected from the group consisting of a cured product of the thermosetting resin composition according to any one of [1] to [8], a cured product of the prepreg according to [9], and the laminate according to [11].

[13] An antenna device including the laminate according to [11] or the printed wiring board according to [12].

[14] An antenna module including a feeding circuit and the antenna device according to [13].

[15] A communication device including a baseband signal processing circuit and the antenna module according to [14].

Advantageous Effects of Invention

According to the present disclosure, it is possible to provide a thermosetting resin composition that contains a high dielectric constant material and that can suppress, in producing a cured product thereof, generation of outgas, decrease in heat resistance, and decrease in peel strength, and to provide a prepreg, a resin film, a laminate, a printed wiring board, an antenna device, an antenna module, and a communication device obtained by using the thermosetting resin composition.

Description of Embodiments

In the numerical ranges described in the present disclosure, the upper limit values or the lower limit values of the numerical ranges may each be replaced with a value shown in Examples. In addition, the lower limit values and the upper limit values of the numerical ranges can be arbitrarily combined with a lower limit value or an upper limit value of another numerical range. In the notation of the numerical range "AAto BB", the numerical values AA and BB at the ends are included in the numerical range as the lower limit value and the upper limit value, respectively.

In the present disclosure, for example, the description of "10 or more" means 10 and numerical values exceeding 10, and the same applies to cases of different numerical values. Further, for example, the description of "10 or less" means 10 and numerical values less than 10, and the same applies to cases of different numerical values.

In addition, regarding each component and material exemplified in the present disclosure, one kind may be used alone or two or more kinds may be used in combination unless otherwise specified. In the present disclosure, when a plurality of substances corresponding to each component are present in a composition, the content of the component in the composition means the total amount of the plurality of substances present in the composition unless otherwise specified.

In the present disclosure, the "resin component" refers to all of the solid components constituting the resin composition except for inorganic compounds, such as a high dielectric constant inorganic filler and an inorganic filler to be described later.

In the present disclosure, the "solid components" refer to components in the resin composition other than an organic solvent. That is, the solid components also include components in a liquid state, a syrup state, or a wax state at room temperature around 25°C in addition to components in a solid state at room temperature around 25°C.

The expression "containing XX" described in the present disclosure naturally includes containing XX, but also includes containing XX in a reacted state.

An aspect in which matters described in the present disclosure are arbitrarily combined is also included in the present disclosure and the present embodiment.

[Thermosetting Resin Composition]

The thermosetting resin composition of the present embodiment is as follows.

A thermosetting resin composition containing:

(A) a thermosetting resin [hereinafter, sometimes referred to as component (A)]; and
(B) at least one high dielectric constant inorganic filler selected from the group consisting of a titanium-based inorganic filler and a zircon-based inorganic filler [hereinafter, sometimes referred to as component (B)],

the thermosetting resin composition further containing (C) a resin having 3% by mass or more of an acidic group [hereinafter sometimes referred to as component (C)] in an amount of 1 part by mass or more with respect to 100 parts by mass of the component (B).

Hereinafter, the components that the thermosetting resin composition of the present embodiment contains will be described in detail in order.

((A) Thermosetting Resin)

Examples of the component (A) include an epoxy resin, a maleimide compound, a modified polyphenylene ether resin, a phenol resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. Among them, the component (A) is preferably an epoxy resin, a maleimide compound, and a polyphenylene ether resin. From the viewpoints of low thermal expansion and heat resistance, the component (A) is more preferably an epoxy resin and a maleimide compound, and from the viewpoints of low thermal expansion, dielectric dissipation factor (Df), and the like, the component (A) is more preferably a maleimide compound and a polyphenylene ether resin.

As the component (A), one kind may be used alone or two or more kinds may be used in combination.

The epoxy resin is preferably an epoxy resin having two or more epoxy groups in one molecule. Here, epoxy resins are classified into glycidyl ether type epoxy resins, glycidyl amine type epoxy resins, glycidyl ester type epoxy resins, and the like. Among them, glycidyl ether type epoxy resins are preferable.

Epoxy resins are also classified into various types of epoxy resins according to the difference in the main skeleton, and each of the above types of epoxy resins is further classified into bisphenol type epoxy resins, such as bisphenol A type epoxy resins, bisphenol F type epoxy resins, and bisphenol S type epoxy resins; alicyclic epoxy resins, such as dicyclopentadiene type epoxy resins; aliphatic chain epoxy resins; novolac type epoxy resins, such as phenol novolac type epoxy resins, cresol novolac type epoxy resins, bisphenol A novolac type epoxy resins, bisphenol F novolac type epoxy resins, phenol aralkyl novolac type epoxy resins, and biphenyl aralkyl novolac type epoxy resins; stilbene type epoxy resins; naphthalene skeleton-containing epoxy resins, such as naphthol novolac type epoxy resins and naphthol aralkyl type epoxy resins; biphenyl aralkyl type epoxy resins; xylylene type epoxy resins; and dihydroanthracene type epoxy resins.

The maleimide compound preferably includes at least one selected from the group consisting of maleimide compounds having one or more (preferably two or more) N-substituted maleimide groups and derivatives thereof.

Examples of the maleimide compounds having one or more N-substituted maleimide groups include, but are not particularly limited to, aromatic maleimide compounds having one N-substituted maleimide group preferably bonded to an aromatic ring, such as N-phenylmaleimide, N-(2-methylphenyl)maleimide, N-(4-methylphenyl)maleimide, N-(2,6-dimethylphenyl)maleimide, N-(2,6-diethylphenyl)maleimide, N-(2-methoxyphenyl)maleimide, and N-benzylmaleimide; aromatic bismaleimide compounds having two N-substituted maleimide groups preferably bonded to an aromatic ring, such as bis(4-maleimidophenyl)methane, bis(4-maleimidophenyl) ether, bis(4-maleimidophenyl) sulfone, 3,3'-dimethyl-5,5'-diethyl-4,4'-diphenylmethane bismaleimide, 4-methyl-1,3-phenylene bismaleimide, m-phenylene bismaleimide, 2,2-bis[4-(4-maleimidophenoxy)phenyl]propane, and indane ring-containing bismaleimide; aromatic polymaleimide compounds having three or more N-substituted maleimide groups preferably bonded to an aromatic ring, such as polyphenylmethane maleimide and biphenyl aralkyl type maleimide; and aliphatic maleimide compounds, such as N-dodecylmaleimide, N-isopropylmaleimide, N-cyclohexylmaleimide, 1,6-bismaleimido-(2,2,4-trimethyl)hexane, and a pyrophosphoric acid binder type long chain alkyl bismaleimide. Among them, from the viewpoints of compatibility with other resins, peel strength, heat resistance, low thermal expansion, and mechanical properties, an aromatic bismaleimide compound having two N-substituted maleimide groups preferably bonded to an aromatic ring is more preferable, and 2,2-bis[4-(4-maleimidophenoxy)phenyl]propane is further preferable.

A maleimide compound having one or more N-substituted maleimide groups may be a maleimide compound having two or more N-substituted maleimide groups, and in this case, it is preferable, in the maleimide compound having two or more N-substituted maleimide groups, that the nitrogen atoms that the at least two maleimide groups have are linked via an organic group. Examples of the organic group include an aliphatic hydrocarbon group and an aromatic hydrocarbon group which optionally contain a hetero atom, a heteroaromatic hydrocarbon group, and a group which is a combination thereof.

Examples of the derivatives of the maleimide compounds include addition reaction products of the maleimide compounds having one or more (preferably two or more) N-substituted maleimide groups and an amine compound, such as a monoamine compound or a diamine compound (hereinafter, sometimes referred to as a "modified maleimide compound"). Examples of the monoamine compound include monoamine compounds having an acidic substituent, such as o-aminophenol, m-aminophenol, p-aminophenol, o-aminobenzoic acid, m-aminobenzoic acid, p-aminobenzoic acid, o-aminobenzenesulfonic acid, m-aminobenzenesulfonic acid, p-aminobenzenesulfonic acid, 3,5-dihydroxyaniline, and 3,5-dicarboxyaniline. Examples of the diamine compound include 4,4'-diaminodiphenylmethane, 4,4'-diaminodiphenyl-lethane, 4,4'-diaminodiphenylpropane, 2,2-bis[4-(4-aminophenoxy)phenyl]propane, 2,2-bis(4,4'-diaminodiphenyl)propane, 3,3'-dimethyl-4,4'-diaminodiphenylmethane, 3,3'-diethyl-4,4'-diaminodiphenylmethane, 3,3'-dimethyl-4,4'-diaminodiphenylethane, 3,3'-diethyl-4,4'-diaminodiphenylethane, 4,4'-diaminodiphenyl ether, 4,4'-diaminodiphenyl thioether, 3,3'-dihydroxy-4,4'-diaminodiphenylmethane, 2,2',6,6'-tetramethyl-4,4'-diaminodiphenylmethane, 3,3'-dichloro-4,4'-diaminodiphenylmethane, 3,3'-dibromo-4,4'-diaminodiphenylmethane, 2,2',6,6'-tetrachloro-4,4'-diaminodiphenylmethane, 2,2',6,6'-tetrabromo-4,4'-diaminodiphenylmethane, and siloxane diamine. Among them, 2,2-bis[4-(4-aminophenoxy)phenyl]propane, 3,3'-dimethyl-4,4'-diamnodiphenylmethane, and cyclohexanediamine are preferable.

As each of the monoamine compound and the diamine compound, one kind may be used alone or two or more kinds may be used in combination.

As the maleimide compound, an addition reaction product of a maleimide compound having two or more N-substituted maleimide groups and an amine compound is preferably contained, an addition reaction product of a maleimide compound having two or more N-substituted maleimide groups and a diamine compound is more preferably contained, and an addition reaction product of a maleimide compound having two or more N-substituted maleimide groups and a diamine compound containing a siloxane diamine is further preferably contained.

The modified polyphenylene ether resin is preferably a polyphenylene ether resin having an ethylenically unsaturated bond-containing group at a terminal, and more preferably a polyphenylene ether resin having an ethylenically unsaturated bond-containing group at both the terminals. Here, the "ethylenically unsaturated bond-containing group" means a substituent containing a carbon-carbon double bond capable of an addition reaction, and does not include a double bond of an aromatic ring. Examples of the ethylenically unsaturated bond-containing group include unsaturated aliphatic hydrocarbon groups, such as a vinyl group, an allyl group, a 1-methylallyl group, an isopropenyl group, a 2-butenyl group, a 3-butenyl group, and a styryl group; and groups containing a hetero atom and an ethylenically unsaturated bond, such as a maleimide group and a (meth)acryloyl group. As the ethylenically unsaturated bond-containing group, a group containing a hetero atom and an ethylenically unsaturated bond is preferable, a (meth)acryloyl group is more preferable, and a methacryloyl group is further preferable.

In the present disclosure, the "(meth)acryloyl group" means an acryloyl group or a methacryloyl group.

(Content of Component (A))

The content of the thermosetting resin (A) in the thermosetting resin composition of the present embodiment is not particularly limited, and, from the viewpoints of dielectric dissipation factor (Df), heat resistance, and moldability, is preferably 5 to 95 parts by mass, more preferably 10 to 80 parts by mass, further preferably 10 to 60 parts by mass, and particularly preferably 15 to 40 parts by mass, based on 100 parts by mass of the total amount of solid components in the thermosetting resin composition.

((B) At Least One High Dielectric Constant Inorganic Filler Selected from Group Consisting of Titanium-Based Inorganic Filler and Zircon-Based Inorganic Filler)

The titanium-based inorganic filler is, from the viewpoint of the dielectric constant (Dk), preferably at least one selected from the group consisting of titanium dioxide and a metal titanate. From the viewpoint of dielectric constant (Dk), examples of the metal titanate include an alkali metal titanate, such as potassium titanate; alkaline earth metal titanates, such as barium titanate, calcium titanate, and strontium titanate; and lead titanate. The metal titanate is preferably at least one selected from the above examples, and from the viewpoint of the dielectric constant (Dk), is more preferably an alkaline earth metal titanate, and further preferably calcium titanate or strontium titanate.
The zircon-based inorganic filler is, from the viewpoint of the dielectric constant (Dk), preferably an alkali metal zirconate. The alkali metal zirconate is, from the viewpoint of the dielectric constant (Dk), preferably at least one selected from the group consisting of calcium zirconate and strontium zirconate.
The component (B) is, from the viewpoints of dielectric dissipation factor (Df) and specific gravity, preferably a titanium-based inorganic filler, and more preferable components are as described above.
The average particle size of the component (B) is not particularly limited, and is preferably 0.1 $\mu$m or more, more preferably 0.4 $\mu$m or more, and from the viewpoint of heat resistance, further preferably 1.0 $\mu$m or more, and particularly preferably 1.5 $\mu$m or more. The upper limit of the average particle size of the component (B) is, from the viewpoint of excluding coarse particles which possibly cause insulation failure, preferably 4.5 $\mu$m or less, more preferably 4.0 $\mu$m or less, further preferably 3.5 $\mu$m or less, particularly preferably 3.0 $\mu$m or less, and most preferably 2.5 $\mu$m or less.
Thus, the average particle size of the component (B) is preferably 0.1 to 4.5 $\mu$m, and the upper limit and the lower limit in this numerical range can be changed based on the above description.
Here, in the present disclosure, the average particle size refers to an average primary particle size.
In the present disclosure, the average particle size is a value of d50 (median diameter of volume distribution) obtained by analysis of a particle size distribution using a particle size distribution analyzer. The specific method and conditions for analyzing the particle size distribution may be any method and conditions according to description in the section of Examples.
The shape of the component (B) is not particularly limited, and since an industrially available high dielectric constant inorganic filler generally has an irregular shape in many cases, the shape may be an irregular shape, although may be another shape such as a spherical shape.

(Content of Component (B))

The content of the component (B) in the thermosetting resin composition of the present embodiment is not particularly limited, and from the viewpoint of the dielectric constant (Dk), the content based on the total amount of solid components in the thermosetting resin composition is preferably 1 to 60% by volume, more preferably 2 to 30% by volume, may be 3 to 20% by volume, may be 7 to 30% by volume, and may be 12 to 25% by volume. When the content of the component (B) is described in parts by mass, the content based on 100 parts by mass of the total amount of solid components in the thermosetting resin composition is preferably 5 to 95 parts by mass, more preferably 15 to 90 parts by mass, further preferably 20 to 70 parts by mass, particularly preferably 20 to 55 parts by mass, and most preferably 25 to 50 parts by mass.
When the content of the component (B) in the thermosetting resin composition of the present embodiment is the above lower limit value or more, the dielectric constant (Dk) tends to be sufficiently increased, and when the content thereof is the above upper limit value or less, excessive increase in the dielectric dissipation factor (Df) tends to be suppressed.

((C) Resin Having 3% by Mass or More of Acidic Group)

The thermosetting resin composition of the present embodiment contains, as a component (C), a resin having 3% by mass or more of an acidic group in an amount of 1 part by mass or more with respect to 100 parts by mass of the component (B). Thus, in spite of the fact that the thermosetting resin composition of the present embodiment contains the component (B), generation of outgas, decrease in heat resistance, and decrease in peel strength can be suppressed in producing a cured product of the thermosetting resin composition. The reason why such effects can be achieved is inferred as follows: by incorporating a resin having a certain amount or more of an acidic group into the thermosetting composition in a certain amount or more, the tendency toward the basicity of the thermosetting composition due to the component (B) is suppressed, for example, to reduce the surface activity (catalytic activity) of the component (B), whereby degradation of the component (A) (breakage of the molecular bond), deterioration of the component (A), and the like are suppressed. However, even if this inference is not correct, this is not to affect the scope of the present disclosure.

For achieving the effects as described above, regarding the component (C), the content of the acidic group in the resin (component (C)) is 3 % by mass or more, and the component (C) is incorporated in an amount of 1 part by mass or more with respect to 100 parts by mass of the component (B). For achieving the effects as described above, the content of the acidic group is preferably 3 to 40% by mass, more preferably 5 to 35% by mass, further preferably 7 to 30% by mass, and particularly preferably 9 to 25% by mass. When the content of the acidic group in the resin (component (C)) is 40% by mass or less, reduction in the compatibility with other resins and decrease in heat resistance tend to be suppressed. Here, the content of the acidic group is a value calculated by a titration method, and more specifically, can be measured by a method described in the section of Examples.

For achieving the effects as described above, the component (C) is preferably incorporated in an amount of 1 to 40 parts by mass with respect to 100 parts by mass of the component (B), more preferably incorporated in an amount of 2 to 35 parts by mass, further preferably incorporated in an amount of 3 to 30 parts by mass, and particularly preferably incorporated in an amount of 3 to 25 parts by mass. When the amount of the component (C) is 40 parts by mass or less with respect to 100 parts by mass of the component (B), a superior dispersibility of the component (C) tends to be achieved and furthermore, decrease in the flame retardancy and excessive increase in the dielectric dissipation factor (Df) tends to be suppressed.

The acidic group that the component (C) has is preferably at least one selected from the group consisting of a carboxylic anhydride group, a carboxy group, a sulfo group, and a phenolic hydroxy group, more preferably at least one selected from the group consisting of a carboxylic anhydride group and a carboxy group, and further preferably a carboxylic anhydride group.

As the component (C), specifically, a copolymer resin of an aromatic vinyl compound and maleic anhydride [hereinafter sometimes referred to as copolymer resin (C-1)] is preferable. Examples of the aromatic vinyl compound include styrene, 1-methylstyrene, vinyltoluene, and dimethylstyrene. As the aromatic vinyl compound, styrene is preferably contained.

The copolymer resin (C-1) may be a copolymer of various polymerizable components other than the aromatic vinyl compound and maleic anhydride. Examples of the various polymerizable components include a vinyl compound, such as ethylene, propylene, butadiene, isobutylene, or acrylonitrile; and a compound having a (meth)acryloyl group, such as methyl acrylate or methyl methacrylate.

The copolymer resin (C-1) may further have an alkenyl group, such as an allyl group, a (meth)acryloyl group, a hydroxy group, or other substituents. The substituents can be introduced into the copolymer resin (C-1) through a Friedel-Crafts reaction or a reaction using a catalyst based on a metal, such as lithium.

In the copolymer resin (C-1), the ratio of the aromatic vinyl compound unit to the maleic anhydride unit contained [aromatic vinyl compound unit / maleic anhydride unit] (molar ratio) is preferably 2 to 12, more preferably 3 to 10. When the ratio of contents is 2 or more, the heat resistance tends to be sufficient, and when the ratio is 12 or less, generation of outgas, decrease in heat resistance, decrease in peel strength, and excessive increase in the dielectric dissipation factor (Df) tend to be easily suppressed.

The total content of the aromatic vinyl compound unit and the maleic anhydride unit in the copolymer resin (C-1) is, from the viewpoints of suppressing generation of outgas, decrease in heat resistance, and decrease in peel strength, preferably 50% by mass or more, more preferably 70% by mass or more, further preferably 90% by mass or more, and particularly preferably substantially 100% by mass.

The weight average molecular weight (Mw) of the component (C) and the copolymer resin (C-1) is preferably 5,000 to 18,000, more preferably 6,000 to 17,000, further preferably 8,000 to 16,000, and particularly preferably 9,000 to 16,000, and may be 10,000 to 16,000, may be 9,000 to 12,500, or may be 125,00 to 16,000. Note that, all the weight average molecular weights in the present disclosure are each a value measured by a gel permeation chromatography (GPC) method (based on standard polystyrenes) using tetrahydrofuran as an eluent.

The thermosetting resin composition of the present embodiment may further contain other component. The other component is not particularly limited, and one or more selected from the group consisting of (D) an elastomer, (E) an inorganic filler [excluding the component (B)], a coupling agent, (F) a curing accelerator, (G) an antioxidant, (H) a flame retardant, a flame retardant auxiliary, an adhesiveness improver, a heat stabilizer, an antistatic agent, an ultraviolet absorber, a pigment, a colorant, and a lubricant are preferably contained.

((D Elastomer)

The thermosetting resin composition of the present embodiment preferably further contains (D) an elastomer, although not particularly limited thereto. The component (D) does not include the component (C).

Examples of the elastomer (D) include styrene elastomers, olefin elastomers, urethane elastomers, polyester elastomers, polyamide elastomers, acrylic elastomers, and silicone elastomers. These elastomers are composed of a hard segment component and a soft segment component, and generally, the hard segment component contributes to heat resistance and strength, and the soft segment component contributes to flexibility and toughness.

As the elastomer (D), one kind may be used alone or two or more kinds may be used in combination.

The elastomer (D) is, from the viewpoint of dielectric dissipation factor (Df), preferably a styrene elastomer, and more preferably a styrene-based thermoplastic elastomer. The styrene elastomer may be any that has a structural unit derived from a styrene compound, and from the viewpoints of dielectric dissipation factor (Df), peel strength, heat resistance, and low thermal expansion, the styrene elastomer is preferably one or more selected from the group consisting of a hydrogenated styrene-butadiene-styrene block copolymer (SEBS) and a hydrogenated styrene-isoprene-styrene block copolymer (SEPS), more preferably a hydrogenated styrene-butadiene-styrene block copolymer (SEBS).

The styrene elastomer may be modified with an acid anhydride, such as maleic anhydride. Examples thereof include SEBS modified with an acid anhydride, such as maleic anhydride, and SEPS modified with an acid anhydride, such as maleic anhydride. The acid number of the acid-modified styrene elastomer is not particularly limited, and is preferably 2 to 20 $mgCH_3ONa/g$, more preferably 5 to 15 $mgCH_3ONa/g$, and further preferably 7 to 13 $mgCH_3ONa/g$.

In the styrene elastomer, the content of the structural unit derived from styrene [hereinafter, sometimes referred to as "styrene content"] is not particularly limited, and from the viewpoints of dielectric dissipation factor (Df), peel strength, heat resistance, and low thermal expansion, is preferably 5 to 80% by mass, more preferably 10 to 75% by mass, further preferably 15 to 60% by mass, and particularly preferably 20 to 45% by mass.

The weight-average molecular weight (Mw) of the styrene elastomer is not particularly limited, and is preferably 12,000 to 1,000,000, more preferably 30,000 to 500,000, further preferably 50,000 to 120,000, and particularly preferably 70,000 to 100,000. The weight-average molecular weight (Mw) means a value measured by gel permeation chromatography (GPC) based on polystyrene.

(Content of elastomer (D))

In the case where the thermosetting resin composition of the present embodiment contains the elastomer (D), the content thereof is not particularly limited, and is preferably 0.1 to 20 parts by mass based on 100 parts by mass of the total amount of solid components in the thermosetting resin composition, more preferably 0.5 to 15 parts by mass, and further preferably 1.0 to 10 parts by mass. When the content of the elastomer (D) is the above lower limit or more, a more superior dielectric dissipation factor (Df) tends to be achieved, and when the content is the above upper limit or less, a good heat resistance, moldability, processability, and flame retardancy tend to be achieved.

((E) Inorganic filler)

The thermosetting resin composition of the present embodiment preferably further contains (E) an inorganic filler, although not particularly limited thereto.

By incorporating the inorganic filler (E) in the thermosetting resin composition of the present embodiment, more superior low thermal expansion, high elastic modulus, heat resistance, and flame retardancy tend to be achieved. However, the inorganic filler (E) does not include the component (B).

As the inorganic filler (E), one kind may be used alone or two or more kinds may be used in combination.

Examples of the inorganic filler (E) include silica, alumina, mica, beryllia, aluminum carbonate, magnesium hydroxide, aluminum hydroxide, aluminum silicate, calcium carbonate, calcium silicate, magnesium silicate, silicon nitride, boron nitride, clay such as calcined clay, a molybdic acid compound such as zinc molybdate, talc, aluminum borate, and silicon carbide. Among them, from the viewpoints of low thermal expansion, elastic modulus, heat resistance, and flame retardancy, silica, alumina, mica, and talc are preferable, silica and alumina are more preferable, and silica is further preferable. Examples of the silica include crushed silica, fumed silica, and fused silica. Among them, fused silica is preferable, and fused spherical silica is more preferable.

The average particle diameter of the inorganic filler (E) is not particularly limited, and is preferably 0.01 to 20 $\mu$m, more preferably 0.1 to 10 $\mu$m, further preferably 0.2 to 3 $\mu$m, and particularly preferably 0.3 to 1.0 $\mu$m.

(Content of Inorganic Filler (E))

In the case where the thermosetting resin composition of the present embodiment contains the inorganic filler (E), the content thereof is not particularly limited, and in any case, from the viewpoints of thermal expansion coefficient, elastic modulus, heat resistance, and flame retardancy, the content based on the total amount of solid components in the thermosetting resin composition is preferably 3 to 70% by volume, more preferably 5 to 65% by volume, further preferably 5 to 60% by volume, furthermore preferably 10 to 50% by volume, particularly preferably 10 to 40% by volume, and most preferably 10 to 30% by volume.

When the content of the component (E) is expressed in parts by mass, the content is preferably 1 to 60 parts by mass, more preferably 5 to 50 parts by mass, further preferably 10 to 45 parts by mass, particularly preferably 15 to 45 parts by mass, and most preferably 20 to 40 parts by mass, based on 100 parts by mass of the total amount of solid components in the thermosetting resin composition.

In the case where the inorganic filler is used, a coupling agent may be used together as necessary for the purpose of improving the dispersibility of the inorganic filler and the adhesiveness between the inorganic filler and the organic components in the resin composition. Examples of the coupling agent include a silane coupling agent and a titanate coupling agent. As the coupling agent, one kind may be used alone or two or more kinds may be used in combination.

In the case where the coupling agent is used, the treatment method may be a so-called integral blend treatment method in which the inorganic filler is blended in the resin composition and then the coupling agent is added, and a method of using the inorganic filler previously surface-treated with the coupling agent by a dry or wet method is preferable. By adopting this method, the characteristics of the inorganic filler can be more effectively exhibited.

In addition, the inorganic filler may be used as a slurry in which the inorganic filler is dispersed in an organic solvent in advance, as necessary.

((F) Curing Accelerator)

The thermosetting resin composition of the present embodiment preferably further contains (F) a curing accelerator, although not particularly limited thereto.

Examples of the curing accelerator (F) include amine-based curing accelerators, imidazole-based curing accelerators, phosphorus-based curing accelerators, organometallic salts, acidic catalysts, and organic peroxides. In the present embodiment, imidazole-based curing accelerators are not classified as amine-based curing accelerators. As the curing accelerator, one kind may be used alone or two or more kinds may be used in combination. The curing accelerator is preferably an amine-based curing accelerator, an imidazole-based curing accelerator, or a phosphorus-based curing accelerator.

Examples of the amine-based curing accelerator include amine compounds having a primary to tertiary amino group, such as triethylamine, 4-aminopyridine, tributylamine, and dicyandiamide; and quaternary ammonium compounds.

Examples of the imidazole-based curing accelerator include imidazole compounds, such as methylimidazole, phenylimidazole, 2-undecylimidazole, and isocyanate-masked imidazole (for example, an addition reaction product of a hexamethylene diisocyanate resin and 2-ethyl-4-methylimidazole).

Examples of the phosphorus-based curing accelerator include a tertiary phosphine, such as triphenylphosphine; and a quaternary phosphonium compound such as a tri-n-butylphosphine addition reaction product of p-benzoquinone.

(Content of Curing Accelerator (F))

In the case where the thermosetting resin composition of the present embodiment contains the curing accelerator (F), the content thereof is not particularly limited, and in any case, the content based on 100 parts by mass of the total amount of the resin components in the thermosetting resin composition is preferably 0.01 to 3 parts by mass, more preferably 0.05 to 2.5 parts by mass, further preferably 0.1 to 2.5 parts by mass, and particularly preferably 0.5 to 2.3 parts by mass. When the content of the curing accelerator (F) is within the above range, more favorable dielectric dissipation factor (Df), heat resistance, storage stability, and moldability tend to be achieved.

(Antioxidant (G) )

The thermosetting resin composition of the present embodiment preferably further contains (G) an antioxidant, although not particularly limited thereto.

The antioxidant is not particularly limited, and examples thereof include phenol-based antioxidants, such as a hindered phenol-based antioxidant and a styrenated phenol-based antioxidant.

(Content of antioxidant (G))

In the case where the thermosetting resin composition of the present embodiment contains the antioxidant (G), the content thereof is not particularly limited, and in any case, the content based on 100 parts by mass of the total amount of solid components in the thermosetting resin composition is preferably 0.01 to 3 parts by mass, more preferably 0.05 to 2.5 parts by mass, further preferably 0.1 to 2.0 parts by mass, and particularly preferably 0.5 to 1.5 parts by mass. When the content of the antioxidant (G) is within the above range, the storage stability of a vanish as described later is improved, and furthermore, decrease in heat resistance, decrease in peel strength, and excessive increase in the dielectric dissipation factor (Df) tend to be easily suppressed.

((H) Flame Retardant)

The thermosetting resin composition of the present embodiment preferably further contains (H) a flame retardant, although not particularly limited thereto.

Examples of the flame retardant (H) include inorganic phosphorus-based flame retardants; organic phosphorus-based flame retardants; and metal hydrates, such as a hydrate of aluminum hydroxide and a hydrate of magnesium hydroxide. The metal hydroxide may also belong to the inorganic filler, but in the case of a metal hydroxide capable of imparting flame retardancy, the metal hydroxide is classified as a flame retardant. Among them, the flame retardant (H) is preferably an organic phosphorus-based flame retardant.

Examples of the organic phosphorus-based flame retardant include aromatic phosphate esters, phosphonate diesters, and phosphinate esters; phosphinic acid metal salts, organic nitrogen-containing phosphorus compounds, and cyclic organophosphorus compounds. Here, examples of the "metal salts" include lithium salts, sodium salts, potassium salts, calcium salts, magnesium salts, aluminum salts, titanium salts, and zinc salts. Among them, the organic phosphorus-based flame retardant is preferably an aromatic phosphate ester.

(Content of Flame Retardant (H))

In the case where the thermosetting resin composition of the present embodiment contains the flame retardant (H), the content thereof is not particularly limited, and in any case, the content based on 100 parts by mass of the total amount of solid components in the thermosetting resin composition is preferably 0.1 to 30 parts by mass, may be 1 to 25 parts by mass, may be 3 to 20 parts by mass, and may be 5 to 15 parts by mass. When the content of the flame retardant (H) is the above lower limit value or more, more favorable flame retardancy tends to be achieved. When the content of the flame retardant (H) is the above upper limit value or less, more favorable moldability, peel strength, and more superior heat resistance tend to be achieved.

(Content of Components Other Than Above-described Components)

In the case where the thermosetting resin composition of the present embodiment contains components other than the above-described components (a flame retardant aid, an adhesiveness improver, a heat stabilizer, an antistatic agent, an ultraviolet absorber, a pigment, a colorant, a lubricant, and other components), the content of each component is not particularly limited, and, for example, the content with respect to 100 parts by mass of the total amount of the resin components of the thermosetting resin composition is 0.01 parts by mass or more, and may be 10 parts by mass or less, may be 5 parts by mass or less, may be 1 part by mass or less, or such other components need not be contained.

(Organic Solvent)

The thermosetting resin composition of the present embodiment may be a so-called "varnish" containing an organic solvent from the viewpoint of easy handling and from the viewpoint of easy production of a prepreg described later.

Examples of the organic solvent include, but are not particularly limited to, alcohol-based solvents, such as ethanol, propanol, butanol, methyl cellosolve, butyl cellosolve, and propylene glycol monomethyl ether; ketone-based solvents, such as acetone, methyl ethyl ketone, methyl isobutyl ketone, and cyclohexanone; an ether-based solvent, such as tetrahydrofuran; aromatic solvents, such as toluene, xylene, and mesitylene; nitrogen atom-containing solvents, such as dimethylformamide, dimethylacetamide, and N-methylpyrrolidone; a sulfur atom-containing solvent, such as dimethyl sulfoxide; and an ester-based solvent, such as $\gamma$-butyrolactone. From the viewpoint of solubility, ketone-based solvents are preferable, and methyl isobutyl ketone is more preferable. As the organic solvent, one kind may be used alone or two or more kinds may be used in combination.

In the case where the thermosetting resin composition of the present embodiment is used as a varnish, the concentration of solid components is preferably 30 to 90% by mass, more preferably 40 to 80% by mass, and further preferably 55 to 70% by mass. When the concentration of solid components in the thermosetting resin composition is within the above range, the handling of the thermosetting resin composition is easy, the impregnation into a base material and the appearance of a prepreg produced are good, and the coatability in forming a resin film is also good.

The thermosetting resin composition of the present embodiment can be produced by mixing the components (A) to (C), and the components that can be used as necessary by a known method. At this time, the components may be dissolved or dispersed in the organic solvent with stirring. Conditions, such as mixing order, temperature, and time, are not particularly limited, and can be arbitrarily set.

Since the thermosetting resin composition of the present embodiment can exhibit a high dielectric constant (Dk) and a low dielectric dissipation factor (Df), the thermosetting resin composition is useful for an antenna module, in particular, for a miniaturized antenna module applicable to the fifth generation mobile communication system (5G).

[Prepreg]

The prepreg of the present embodiment is a prepreg containing the thermosetting resin composition of the present embodiment or a semi-cured product of the thermosetting resin composition.

The prepreg of the present embodiment contains, for example, the thermosetting resin composition of the present embodiment or a semi-cured product of the thermosetting resin composition and a sheet-shaped fiber base material. The prepreg is formed using the thermosetting resin composition of the present embodiment and the sheet-shaped fiber base material, and can be obtained, for example, by impregnating or coating the sheet-shaped fiber base material with the thermosetting resin composition of the present embodiment, drying, and semi-curing (B-staging) the resultant as necessary. More specifically, for example, the prepreg of the present embodiment can be produced through drying with heat usually at a temperature of 80 to 200°C for 1 to 30 minutes in a drying furnace, followed by semi-curing (B-staging). Here, in the present disclosure, B-staging is to bring into a B-stage state as defined in JIS K6900 (1994).

The amount of the thermosetting resin composition to be used can be appropriately determined for the purpose of bringing the concentration of solid components derived from the thermosetting resin composition in the prepreg after drying into 30 to 90% by mass. When the concentration of solid components is within the above-described range, better moldability tends to be achieved in forming a laminate.

As the sheet-shaped fiber base material of the prepreg, a known one used for various laminates for electrical insulating materials is used. Examples of the material of the sheet-shaped fiber base material include inorganic fibers, such as E glass, D glass, S glass, and Q glass; organic fibers, such as polyimide, polyester, and tetrafluoroethylene; and mixtures thereof. These sheet-shaped fiber base materials have a shape of, for example, a woven fabric, a nonwoven fabric, a roving, a chopped strand mat, or a surfacing mat.

The thickness of the prepreg is not particularly limited and may be 10 to 170 $\mu$m, may be 10 to 120 $\mu$m, or may be 10 to 70 $\mu$m.

Since the prepreg of the present embodiment can exhibit a high dielectric constant (Dk) and a low dielectric dissipation factor (Df), the prepreg is useful for an antenna module, in particular, for a miniaturized antenna module applicable to 5G.

[Resin Film]

The resin film of the present embodiment is a resin film containing the thermosetting resin composition of the present embodiment or a semi-cured product of the thermosetting resin composition.

The resin film of the present embodiment can be produced, for example, by applying a thermosetting resin composition containing an organic solvent, that is, a varnish, to a support, followed by drying with heat, and semi-curing (B-staging) as necessary.

Examples of the support include a plastic film, a metal foil, and a release paper.

The drying temperature and the drying time may be appropriately determined according to the amount of the organic solvent used, the boiling point of the organic solvent used, and the like, but the resin film can be suitably formed by drying at 50 to 200°C for about 1 to 10 minutes.

Since the resin film of the present embodiment can exhibit a high dielectric constant (Dk) and a low dielectric dissipation factor (Df), the resin film is useful for an antenna module, in particular, for a miniaturized antenna module applicable to 5G.

[Laminate]

The laminate of the present embodiment is a laminate including a cured product of the thermosetting resin composition of the present embodiment or a cured product of the prepreg of the present embodiment, and a metal foil.

The laminate of the present embodiment can be produced, for example, by disposing a metal foil on one surface or both surfaces of a prepreg obtained by stacking two or more sheets of the prepreg of the present embodiment, or disposing a metal foil on one surface or both surfaces of a prepreg obtained by stacking two or more sheets in total of the prepreg of the present embodiment and a prepreg other than that of the present embodiment, followed by heat press molding. In the laminate obtained by the production method, the prepreg of the present embodiment has been C-staged. In the present disclosure, C-staging is to bring into a C-stage state as defined in JIS K6900 (1994). A laminate having a metal foil is sometimes referred to as a metal-clad laminate.

The metal of the metal foil is not particularly limited, and from the viewpoint of conductivity, may be copper, gold, silver, nickel, platinum, molybdenum, ruthenium, aluminum, tungsten, iron, titanium, chromium, or an alloy containing one or more of these metallic elements, and is preferably copper or aluminum, more preferably copper.

The conditions of the heat press molding are not particularly limited, and the heat press molding can be carried out, for example, at a temperature in the range of 100 to 300°C, a pressure in the range of 0.2 to 10 MPa, and for a time period in the range of 0.1 to 5 hours. In addition, a method of maintaining a vacuum state for 0.5 to 5 hours using a vacuum press or the like can be adopted for the heat press molding.

Since the laminate of the present embodiment has a high dielectric constant (Dk) and a low dielectric dissipation factor (Df), the laminate is useful for an antenna module, in particular, for a miniaturized antenna module applicable to 5G.

[Printed wiring board]

The printed wiring board of the present embodiment is a printed wiring board including one or more selected from the group consisting of a cured product of the thermosetting resin composition of the present embodiment and a cured product of the prepreg of the present embodiment. The printed wiring board of the present embodiment can also be said to be a printed wiring board that has one or more selected from the group consisting of a cured product of the thermosetting resin composition of the present embodiment, a cured product of the prepreg of the present embodiment, and the laminate of the present embodiment.

The printed wiring board of the present embodiment can be produced, for example, by using one or more selected from the group consisting of the prepreg of the present embodiment, the resin film of the present embodiment, and the laminate of the present embodiment to perform circuit formation processing through drilling, metal plating, etching of a metal foil, or the like by a known method. A multilayer printed wiring board can also be produced by further performing multilayer adhesion processing as necessary. **In** the printed wiring board of the present embodiment, the prepreg of the present embodiment or the resin film of the present embodiment is a cured product which has been C-staged.

[Antenna Device]

The present disclosure also provides an antenna device including the laminate or the printed wiring board of the present embodiment. The antenna device may be provided with one laminate, or may be provided with a plurality of the laminates or the printed wiring boards. The way of installing the plurality of antenna elements is not particularly limited, and it is preferable to arrange the antenna elements in a two-dimensional array, for example. The configuration of the antenna device is not particularly limited, and, for example, JP 6777273 B can be referred to.

In consideration of use for an antenna module, the laminate or the printed wiring board in the antenna device preferably has a conductor pattern, such as a feeding conductor pattern, a grounding conductor pattern, and a short-circuiting conductor. The short-circuiting conductor is a conductor that short-circuits the feeding conductor pattern and the grounding conductor pattern, and is provided in a via hole portion described below.

The conductor pattern is preferably formed of a metal containing copper, aluminum, gold, silver, and an alloy thereof as a main component.

The laminate or the printed wiring board in the antenna device preferably has a via hole. The via hole makes it possible to form the short-circuiting conductor, and makes it possible to conduct the feeding conductor pattern and the grounding conductor pattern.

The method for forming the via hole is not particularly limited, and a method by laser, plasma, a combination thereof, or the like, can be used. As the laser, a carbon dioxide gas laser, a YAG laser, a UV laser, an excimer laser, or the like can be used.

After the formation of the via hole, for example, a desmearing treatment using an oxidizing agent may be performed. The oxidizing agent is preferably a permanganate, such as potassium permanganate or sodium permanganate; a dichromate; ozone; hydrogen peroxide-sulfuric acid; or nitric acid, more preferably a permanganate, and further preferably an aqueous sodium hydroxide solution of a permanganate, that is, a so-called alkaline permanganate aqueous solution.

The laminate or the printed wiring board in the antenna device preferably includes a short-circuiting conductor formed in the via hole after the formation of the via hole. The conductor used herein is preferably formed of the same metal as the metal that forms the conductor pattern.

[Antenna Module]

The present disclosure also provides an antenna module including a feeding circuit and the antenna device of the present embodiment. The feeding circuit is not particularly limited, and a radio frequency integrated circuit (RFIC) or the like can be used. RFIC includes a switch, a power amplifier, a low-noise amplifier, an attenuator, a phase shifter, a signal synthesizer/demultiplexer, a mixer, and an amplifier circuit.

A high-frequency signal supplied from the RFIC is transmitted via a short-circuiting conductor formed in a via of a laminate for antenna module to a feeding point of a feeding conductor.

The configuration of the antenna module is not particularly limited, and, for example, JP 6777273 B can be referred to.

[Communication Device]

Furthermore, the present disclosure also provides a communication device including a baseband signal processing circuit and the antenna module of the present embodiment.

The communication device of the present embodiment can upconvert a signal transmitted from the baseband signal processing circuit to the antenna module to a high-frequency signal to radiate the signal from the antenna device, and can downconvert a high-frequency signal received by the antenna device to process the signal in the baseband signal processing circuit.

Although preferred embodiments have been described above, these are examples for describing the present disclosure, and the scope of the present disclosure is not to be limited only to these embodiments. The present disclosure may include various aspects different from the embodiment without departing from the gist of the present disclosure.

Examples

Hereinafter, the present embodiment will be specifically described with reference to Examples. However, the present embodiment is not limited to the following Examples.

In each Example, the weight-average molecular weight (Mw) was measured by the following method.

(Method for Measuring Weight-Average Molecular Weight (Mw))

By gel permeation chromatography (GPC), the weight-average molecular weight was determined by conversion based on a calibration curve using standard polystyrenes. The calibration curve was approximated by a cubic equation using standard polystyrenes: TSK standard POLYSTYRENE (Type; A-2500, A-5000, F-1, F-2, F-4, F-10, F-20, F-40) [manufactured by Tosoh Corporation, trade name]. The measurement conditions of GPC are shown below.

Apparatus:

Pump: L-6200 type (manufactured by Hitachi High-Tech Corporation)
Detector: L-3300 type RI (manufactured by Hitachi High-Tech Corporation)
Column oven: L-655A-52 (manufactured by Hitachi High-Tech Corporation)
Column: guard column; TSK Guardcolumn HHR-L + column; TSKgel G4000HHR + TSKgel G2000HHR (all manufactured by Tosoh Corporation, trade names)
Column size: $6.0 \times 40$ mm (guard column), $7.8 \times 300$ mm (column)
Eluent: tetrahydrofuran
Sample concentration: 30 mg/5 mL
Injection volume: 20 $\mu$L
Flow rate: 1.00 mL/min
Measurement temperature: 40°C

The average particle sizes of the component (B) and the component (E) used in each Example were measured by the following method.

(Method for Measuring Average Particle Size)

The particle size distribution was measured with a particle size distribution analyzer "Microtrac MT3300EXII" (manufactured by MicrotracBEL Corp.) to determine the average particle size (d50). Water (containing 0.1% by mass of sodium hexametaphosphate) was used as a measurement solvent, and the measurement was performed in a transmission mode for a measurement time of 30 seconds.

For the component (C) used in each example, the content of the acidic group (acid anhydride group) was measured by the following method.

(Method for Measuring Content of Acidic Group (Acid Anhydride Group))

To a solution obtained by adding 150 mL of acetone to 0.1 g of the component (C) to dissolve the component (C) therein at a room temperature, 3 to 5 drops of a phenol phthalein indicator were added and mixed to prepare a solution a. Separately, 3 to 5 drops of a phenol phthalein indicator were added to and mixed with 150 mL of acetone to prepare a solution b.

Next, using an automatic titrator, each of the solution a and the solution b was titrated with an aqueous 0.1 mol/L NaOH solution (titrant). Subsequently, the solution was titrated with an aqueous 0.05 mol/L $H_2SO_4$ solution (titrant), and the content of the acidic group (acid anhydride group) was calculated using the following expression (1).

$$mgKOH/g = (A-B)C \times 56.1/W \qquad (1)$$

A:     Titer of acetone solution a containing component (C) dissolved (mL)
B:     Titer of acetone solution b (mL)
C:     Molar concentration of titrant $\times$ acid number or base number
W:     Weight of component (C) (g)

[Production Example 1: Production of Modified Maleimide Compound (A-1)]

Into a reaction vessel of a 2 L volume, capable of heating and cooling, equipped with a thermometer, a stirrer, and a water volume meter with a reflux condenser, 15.6 g of a both-terminal diamine-modified siloxane (manufactured by Shin-Etsu Chemical Co., Ltd., trade name: X-22-161B), 21.8 g of 3,3'-diethyl-4,4'-diaminodiphenylmethane, 274.2 g of 2,2-bis [4-(4-meleimidephenoxy)phenyl]propane, and 200.0 g of propylene glycol monomethyl ether were put, and were reacted with refluxing at 120°C for 4 hours to obtain a solution of a modified maleimide compound (A-1). The weight average molecular weight (Mw) of the obtained modified maleimide compound (A-1) was 2,500.

[Production Example 2: Production of Modified Maleimide Compound (A-2)]

Into a reaction vessel of a 2 L volume, capable of heating and cooling, equipped with a thermometer, a stirrer, and a water volume meter with a reflux condenser, 18.6 g of a both-terminal diamine-modified siloxane (manufactured by Shin-Etsu Chemical Co., Ltd., trade name: X-22-161A), 21.8 g of 3,3'-diethyl-4,4'-diaminodiphenylmethane, 272.2 g of 2,2-bis [4-(4-meleimidephenoxy)phenyl]propane, and 200.0 g of propylene glycol monomethyl ether were put, and were reacted with refluxing at 120°C for 4 hours to obtain a solution of a modified maleimide compound (A-2). The weight average molecular weight (Mw) of the obtained modified maleimide compound (A-2) was 2,700.

[Examples 1 to 14, Comparative Examples 1 to 4]

The components shown in Table 1 or 2 were stirred and mixed according to the blending composition shown in Table 1 or 2 together with 58 parts by mass of toluene and 10 parts by mass of methyl isobutyl ketone at room temperature to prepare a thermosetting resin composition (varnish) having a concentration of solid components of 60 to 65% by mass.

The vanish obtained above was applied on a 0.08 mm thick glass cloth (E Glass, manufactured by Nitto Boseki Co., Ltd.), followed by drying with heat at 150°C for 5 minutes to produce a prepreg having a content of solid components derived from the thermosetting resin composition of about 47% by mass. A low-profile copper foil (BF-ANP18, Rz of M surface: 1.5 μm, manufactured by CIRCUIT FOIL Co., Ltd.) having a thickness of 18 μm was disposed on the upper and lower sides of the prepreg so that the M surface (matte surface) was in contact with the prepreg, followed by heat press molding under the conditions of a temperature of 230°C, a pressure of 3.0 MPa, and a time of 90 minutes to produce a double-sided copper-clad laminate (thickness: 0.10 mm).

Using the double-sided copper-clad laminate obtained in each Example, evaluation was performed according to the following methods. The results are shown in Tables 1 and 2.

[Evaluation of Double-Sided Copper-Clad Laminate]

(1. Amont of Outgas (Volatile Gas) Generated)

The outer layer copper foils of the double-sided copper-clad laminate obtained in each Example were removed by dipping in a copper etching solution (10% by mass ammonium persulfate solution, manufactured by Mitsubishi Gas Chemical Company, Inc.), and a piece of a 20 mg weight was taken as a test piece and was subjected to a gas chromatography mass spectrometry to measure the amount of outgas (volatile gas) generated. The total area of the resulting chart was determined and was taken as the amount of outgas generated. As the analyzer, a gas chromatography mass spectrometer "GC-MS QP-2010 Plus" manufactured by Shimadzu Corporation was used.
The thus-determined amount of outgas generated is to be $12.0 \times 10^7$ or less, and preferably $10.0 \times 10^7$ or less, more preferably $8.0 \times 10^7$ or less, and further preferably $6.0 \times 10^7$ or less.

(2. Solder heat resistance)

A test piece obtained by cutting the double-sided copper-clad laminate obtained in each Example into a square with four sides of 50 mm was floated in a solder bath at 288°C and was allowed to stand for 300 seconds. The surface of the test piece was visually observed, and the time (unit: second) until blisters appeared on the surface of the test piece was measured. In the case where no blister appeared even if the test piece was allowed to stand for 300 seconds, ">300" was written in Table 1 or 2.

(3. Peel Strength)

A copper foil of the double-sided copper foil-provided resin plate obtained in each Example was processed by etching into a 3 mm width straight line, followed by drying at 105°C for 1 hour to produce a teat piece. Subsequently, using a small desktop tester (manufactured by Shimadzu Corporation, trade name: EZ-Test), the copper foil which was a straight line on the test piece was peeled in the direction of 90° at a rate of 50 mm/min while measuring the peel strength during the peeling.

(4. Dielectric Constant (Dk) and Dielectric Dissipation Factor (Df))

The outer layer copper foils of the double-sided copper-clad laminate obtained in each Example were removed by dipping in a copper etching solution (10% by mass ammonium persulfate solution, manufactured by Mitsubishi Gas Chemical Company, Inc.), and a piece of a 60 mm length and a 2 mm width was cut out and was taken as a test piece. The dielectric constant (Dk) and the dielectric dissipation factor (Df) thereof were measured by a cavity resonator perturbation method. A vector type network analyzer "N5227A" manufactured by Agilent Technologies, Inc. was used as a measuring instrument, a cavity resonator "CP129" (10 GHz band resonator) manufactured by Kanto Electronics Application & Development Inc. was used as a cavity resonator, and a measurement program "CPMA-V2" was used as a measurement program. The measurement was performed under the conditions of a frequency of 10 GHz and a measurement temperature of 25°C.

Table 1

| | | | unit | Example | | | | | | Comparative Example | | | |
|---|---|---|---|---|---|---|---|---|---|---|---|---|---|
| | | | | 1 | 2 | 3 | 4 | 5 | 6 | 1 | 2 | 3 | 4 |
| Blending composition | (A) Thermosetting resin | A-1 | parts by mass | 23 | 23 | 23 | 23 | 23 | 23 | 23 | | 23 | 23 |
| | | A-2 | | | | | | | | | 23 | | |
| | | A-3 | | | | | | | | | | | |
| | | A-4 | | | | | | | | | | | |
| | | A-5 | | | | | | | | | | | 2 |
| | | A-6 | | 1.5 | | | 1.5 | | | 3 | 3 | | |
| | (B) High dielectric constant inorganic filler | B-1 | parts by mass (% by volume) | | | | | | | | | | |
| | | B-2 | | 34 (15) | 34 (15) | 34 (15) | 34 (15) | 34 (15) | 34 (15) | 34 (15) | 34 (15) | 34 (15) | 34 (15) |
| | (C) Resin having 3% by mass or more of acidic group | C-1 | parts by mass | 1.5 | 3 | 6 | | | | | | | |
| | | C-2 | | | | | 1.5 | 3 | 6 | | | | |
| | (D) Elastomer | D-1 | parts by mass | 5 | 5 | 5 | 5 | 5 | 2 | 5 | 5 | 2 | 2 |
| | (E) Inorganic filler | E-1 | parts by mass (% by volume) | 27 (22) | 27 (22) | 27 (22) | 27 (22) | 27 (22) | 27 (22) | 27 (22) | 27 (22) | 27 (22) | 27 (22) |
| | (F) Curing accelerator | F-1 | parts by mass *1 | 1 | 1 | 1 | 1 | 1 | 1 | 1 | 1 | 1 | 1 |
| | | F-2 | | 0.78 | 0.78 | 0.78 | 0.78 | 0.78 | 0.78 | 0.78 | 0.78 | 0.78 | 0.78 |
| | (G) Antioxidant | G-1 | parts by mass | 0.5 | 0.5 | 0.5 | 0.5 | 0.5 | 0.5 | 0.5 | 0.5 | 6 | 4 |
| | (H) Flame retardant | H-1 | parts by mass | 8 | 8 | 8 | 8 | 8 | 8 | 8 | 8 | 8 | 8 |

EP 4 524 205 A1

16

(continued)

| Evaluation results | | unit | Example | | | | | | Comparative Example | | | |
|---|---|---|---|---|---|---|---|---|---|---|---|---|
| | | | 1 | 2 | 3 | 4 | 5 | 6 | 1 | 2 | 3 | 4 |
| Evaluation results | Amount of outgas generated ($\times 10^7$) | - | 9.05 | 7.46 | 5.43 | 9.68 | 7.73 | 5.75 | 12.05 | 12.20 | 12.31 | 12.13 |
| | Solder heat resistance | seconds | >300 | >300 | >300 | >300 | >300 | >300 | >300 | >300 | 183 | 269 |
| | Peel strength | kN/m | 0.44 | 0.47 | 0.48 | 0.46 | 0.49 | 0.50 | 0.37 | 0.39 | 0.38 | 0.41 |
| | Dielectric constant Dk (10 GHz) | - | 6.0 | 6.0 | 6.1 | 6.0 | 6.0 | 6.1 | 6.0 | 6.0 | 6.0 | 6.0 |
| | Dielectric dissipation factor Df (10 GHz) | - | 0.0052 | 0.0053 | 0.0055 | 0.0052 | 0.0052 | 0.0053 | 0.0052 | 0.0054 | 0.0063 | 0.0065 |

*1: Content with respect to 100 parts by mass of total of resin components in thermosetting resin composition

Table 2

| Blending composition | | | unit | Example | | | | | | | |
|---|---|---|---|---|---|---|---|---|---|---|---|
| | | | | 7 | 8 | 9 | 10 | 11 | 12 | 13 | 14 |
| Blending composition | (A) Thermosetting resin | A-1 | parts by mass | 23 | 21 | 23 | 23 | | 23 | 19.2 | 19.2 |
| | | A-2 | | | | | | 23 | | | |
| | | A-3 | | 2 | 4 | | | | | | |
| | | A-4 | | | | 2 | | | | | |
| | | A-5 | | | | | 2 | 2 | 2 | 1.7 | 1.7 |
| | | A-6 | | | | | | | | | |
| | (B) High dielectric constant inorganic filler | B-1 | parts by mass (% by volume) | | | | | | 34 (15) | | |
| | | B-2 | | 34 (15) | 34 (15) | 34 (15) | 34 (15) | 34 (15) | | 34 (15) | 34 (15) |
| | (C) Resin having 3% by mass or more of acidic group | C-1 | parts by mass | | | | | | | 3.4 | |
| | | C-2 | | 4 | 4 | 4 | 4 | 4 | 4 | | 3.4 |
| | (D) Elastomer | D-1 | parts by mass | 2 | 2 | 2 | 2 | 2 | 2 | 1.7 | 1.7 |
| | (E) Inorganic filler | E-1 | parts by mass (% by volume) | 27 (22) | 27 (22) | 27 (22) | 27 (22) | 27 (22) | 27 (22) | 32 (27) | 32 (27) |
| | (F) Curing accelerator | F-1 | parts by mass *1 | 1 | 1 | 1 | 1 | 1 | 1 | 1 | 1 |
| | | F-2 | | 0.78 | 0.78 | 0.78 | 0.78 | 0.78 | 0.78 | 0.78 | 0.78 |
| | (G) Antioxidant | G-1 | parts by mass | 0.5 | 0.5 | 0.5 | 0.5 | 0.5 | 0.5 | 0.5 | 0.5 |
| | (H) Flame retardant | H-1 | parts by mass | 8 | 8 | 8 | 8 | 8 | 8 | 8 | 8 |
| Evaluation result | Amount of outgas generated ($\times 10^7$) | | - | 5.81 | 5.24 | 5.69 | 5.36 | 5.51 | 5.24 | 5.31 | 5.34 |
| | Solder heat resistance | | seconds | >300 | >300 | >300 | >300 | >300 | >300 | >300 | >300 |
| | Peel strength | | kN/m | 0.53 | 0.55 | 0.50 | 0.52 | 0.53 | 0.51 | 0.52 | 0.54 |
| | Dielectric constant Dk (10 GHz) | | - | 6.0 | 6.2 | 6.0 | 6.0 | 6.0 | 7.1 | 6.0 | 6.0 |
| | Dielectric dissipation factor Df (10 GHz) | | - | 0.0053 | 0.0056 | 0.0053 | 0.0053 | 0.0053 | 0.0060 | 0.0053 | 0.0053 |

*1: Content with respect to 100 parts by mass of total of resin components in thermosetting resin composition

The components described in Tables 1 and 2 are described below.

[(A) Thermosetting resin]

A-1: Modified maleimide compound (A-1) obtained in Production Example 1
A-2: Modified maleimide compound (A-2) obtained in Production Example 2
A-3: Naphthalene skeleton-containing epoxy resin "HP-9540" (manufactured by DIC Corporation)
A-4: Biphenyl aralkyl type epoxy resin "NC-3000-L" (manufactured by Nippon Kayaku Co., Ltd.)
A-5: Naphthalene skeleton-containing epoxy resin (Naphthol Novolac type epoxy resin) "NC-7000-L" (manufactured by Nippon Kayaku Co., Ltd.)
A-6: Polyphenylene ether having methacryloyl group at both terminals of molecule (weight average molecular weight: 1,700)

[(B) High Dielectric Constant Inorganic Filler]

B-1: Strontium titanate, average particle size (d50); 1.6 $\mu$m
B-2: Calcium titanate, average particle size (d50); 2.1 $\mu$m

[(C) Resin Having 3% by Mass or More of Acidic Group]

C-1: Copolymer resin of styrene and maleic anhydride, acidic group (acid anhydride group) content = 19% by mass, styrene / maleic anhydride (molar ratio) = 4, weight average molecular weight = 11,000
C-2: Copolymer resin of styrene and maleic anhydride, acidic group (acid anhydride group) content = 10% by mass, styrene / maleic anhydride (molar ratio) = 8, weight average molecular weight = 14,400

[Elastomer (D): styrene-based thermoplastic elastomer]

D-1: Maleic anhydride-modified hydrogenated styrene-based thermoplastic elastomer (maleic anhydride-modified SEBS), acid number: 10 mgCH$_3$ONa/g, styrene content: 30% by mass

[(E) Inorganic filler ]

E-1: Spherical fused silica: average particle size: 1.5 $\mu$m, 50% by mass slurry (solvent: toluene)

[(F) Curing accelerator]

F-1: Isocyanate-masked imidazole compound
F-2: Dicyandiamide

[Antioxidant (G) ]

G-1: 4,4'-Butylidenebis(6-t-butyl-3-methylphenol)

[(H) Flame retardant ]

H-1: Phosphate ester-based flame retardant

From the results shown in Table 1 and Table 2, it can be understood that, in Examples 1 to 14, the amount of outgas generated is considerably reduced, the solder heat resistance is superior, and the peel strength is higher, as compared with Comparative Examples 1 to 4. In addition to that, a high dielectric constant (Dk) and a low dielectric dissipation factor (Df) can be achieved, and thus, it can be said that a laminate useful for an antenna module could be produced.

On the other hand, it can be understood that, in Comparative Examples 1 to 4 in which the component (C) was not used, the amount of outgas generated is large. In Comparative Examples 1 to 3, the peel strength is also small, and also in Comparative Example 4, the peel strength is insufficient. In particular, it can be understood that, also in Comparative Examples 3 and 4 in which the content of the antioxidant (G) was increased in place of the component (C), the amount of outgas generated could not be reduced, and in addition, the solder heat resistance is decreased.

**Claims**

1. A thermosetting resin composition comprising:

   (A) a thermosetting resin; and
   (B) at least one high dielectric constant inorganic filler selected from the group consisting of a titanium-based inorganic filler and a zircon-based inorganic filler,

   the thermosetting resin composition further containing (C) a resin having 3% by mass or more of an acidic group in an amount of 1 part by mass or more with respect to 100 parts by mass of the component (B).

2. The thermosetting resin composition according to claim 1, wherein the acidic group of the component (C) is at least one selected from the group consisting of a carboxylic anhydride group, a carboxy group, a sulfo group, and a phenolic hydroxy group.

3. The thermosetting resin composition according to claim 1, wherein the component (C) is a copolymer resin of an aromatic vinyl compound and maleic anhydride.

4. The thermosetting resin composition according to claim 1, wherein the titanium-based inorganic filler is at least one selected from the group consisting of titanium dioxide and a metal titanate.

5. The thermosetting resin composition according to claim 4, wherein the metal titanate is at least one selected from the group consisting of an alkali metal titanate, an alkaline earth metal titanate, and lead titanate.

6. The thermosetting resin composition according to claim 1, wherein the zircon-based inorganic filler is an alkali metal zirconate.

7. The thermosetting resin composition according to claim 1, wherein the component (B) is contained in an amount of 1 to 60% by volume based on a total amount of solid components in the thermosetting resin composition.

8. The thermosetting resin composition according to claim 1, wherein the component (A) comprises at least one selected from the group consisting of an epoxy resin, a maleimide compound, a modified polyphenylene ether resin, a phenol resin, a polyimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.

9. A prepreg comprising the thermosetting resin composition according to claim 1 or a semi-cured product of the thermosetting resin composition.

10. A resin film comprising the thermosetting resin composition according to claim 1 or a semi-cured product of the thermosetting resin composition.

11. A laminate comprising a cured product of the thermosetting resin composition according to claim 1 or a cured product of the prepreg according to claim 9, and a metal foil.

12. A printed wiring board comprising one or more selected from the group consisting of a cured product of the thermosetting resin composition according to claim 1 and a cured product of the prepreg according to claim 9.

13. An antenna device comprising the laminate according to claim 11

14. An antenna module comprising a feeding circuit and the antenna device according to claim 13.

15. A communication device comprising a baseband signal processing circuit and the antenna module according to claim 14.

# INTERNATIONAL SEARCH REPORT

| | International application No. |
|---|---|
| | **PCT/JP2023/016561** |

## A. CLASSIFICATION OF SUBJECT MATTER

*C08L 101/00*(2006.01)i; *B32B 15/08*(2006.01)i; *B32B 27/20*(2006.01)i; *C08J 5/24*(2006.01)i; *C08K 3/22*(2006.01)i; *C08K 3/24*(2006.01)i; *C08L 25/08*(2006.01)i; *H01Q 13/08*(2006.01)i; *H05K 1/03*(2006.01)i
FI: C08L101/00; C08K3/24; C08K3/22; C08L25/08; C08J5/24; B32B15/08 U; B32B27/20 Z; H05K1/03 610R; H01Q13/08; H05K1/03 610H

According to International Patent Classification (IPC) or to both national classification and IPC

## B. FIELDS SEARCHED

Minimum documentation searched (classification system followed by classification symbols)

C08L101/00; B32B15/08; B32B27/20; C08J5/24; C08K3/22; C08K3/24; C08L25/08; H01Q13/08; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| Y | JP 2019-011415 A (HITACHI CHEMICAL CO LTD) 24 January 2019 (2019-01-24) claims, paragraph [0087], examples | 1-15 |
| Y | JP 2021-138849 A (SHOWA DENKO MAT CO LTD) 16 September 2021 (2021-09-16) claims, examples | 1-15 |
| Y | JP 2021-187969 A (SUMITOMO BAKELITE CO) 13 December 2021 (2021-12-13) claims, examples | 1-15 |
| Y | JP 2011-236316 A (HITACHI CHEMICAL CO LTD) 24 November 2011 (2011-11-24) claims, examples | 1-15 |
| Y | WO 2018/016489 A1 (HITACHI CHEMICAL CO LTD) 25 January 2018 (2018-01-25) paragraphs [0154]-[0172], examples, fig. 1-3 | 13-15 |
| A | WO 2005/012427 A1 (ZEON CORPORATION) 10 February 2005 (2005-02-10) entire text | 1-15 |

☐ Further documents are listed in the continuation of Box C.  ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **04 July 2023** | **18 July 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
**Information on patent family members**

International application No.

**PCT/JP2023/016561**

| Patent document cited in search report | | | Publication date (day/month/year) | Patent family member(s) | | Publication date (day/month/year) |
|---|---|---|---|---|---|---|
| JP | 2019-011415 | A | 24 January 2019 | (Family: none) | | |
| JP | 2021-138849 | A | 16 September 2021 | (Family: none) | | |
| JP | 2021-187969 | A | 13 December 2021 | (Family: none) | | |
| JP | 2011-236316 | A | 24 November 2011 | (Family: none) | | |
| WO | 2018/016489 | A1 | 25 January 2018 | US 2019/0241729 A1 paragraphs [0126]-[0143], examples, fig. 1-3 EP 3489308 A1 CN 109476923 A KR 10-2019-0031262 A TW 201829584 A | | |
| WO | 2005/012427 | A1 | 10 February 2005 | US 2006/0211809 A1 entire text EP 1652885 A1 KR 10-2006-0097106 A CN 1829771 A AT 425223 T | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005101574 A

- JP 6777273 B